# EUROPEAN PATENT APPLICATION

(11) **EP 4 745 551 A1**
(43) Date of publication of application: **20.05.2026**
(21) Application number: 25210966.5
(22) Date of filing: 24.10.2025
(51) Int. Cl.: G01N 1/28, G01N 1/32

(54) **LAMELLA HOLE TRENCH FILL METHOD**

(30) Priority: 13.11.2024 US 202463719757 P
(71) Applicant: FEI Company, Hillsboro, OR 97124-5793 (US)
(72) Inventor: Totonjian, Daniel, Portland, 97205 (US); Rue, Chad, North Plains, 97133 (US); Mitchson, Gavin, Portland, 97219 (US); Cleveland, Matt, Hillsboro, 97124 (US)
(74) Representative: Robinson, Louise Frances

(57) **Abstract**

The invention relates to the field of lamella preparation, and in particular to a method of filling holes formed during lamella preparation.

## Description

### TECHNICAL FIELD OF THE INVENTION

The present invention relates to the field of lamella preparation, and in particular to a method of filling holes formed during lamella preparation.

### BACKGROUND OF THE INVENTION

Lamella preparation for Electron Microscopy (TEM), such as Transmission Electron Microscopy (TEM) or Scanning Transmission Electron Microscopy (STEM) typically involves using a Focused Ion Beam (FIB) or laser to cut a thin slice (known as a lamella) of the sample of interest (also known as a workpiece) away from the bulk material.

This lamella is then welded or otherwise attached to a lamella carrier which is then transported to a TEM or STEM instrument for further analysis, or another instrument for further processing before making its way to a TEM. This process is critical to many industries such as the semiconductor industry where a TEM is the only instrument which can effectively perform metrology on a single transistor device. This method is also performed in other fields such as life science for the imaging of single cells, materials science for the analysis of crystalline materials, and many more.

Transmission electron microscopes (TEMs) allow observers to see extremely small features, on the order of nanometers. In contrast to SEMs, which only image the surface of a material, TEM also allows analysis of the internal structure of a sample. In a TEM, a broad beam impacts the sample and electrons that are transmitted through the sample are focused to form an image of the sample. The sample must be sufficiently thin to allow many of the electrons in the primary beam to travel though the sample and exit on the opposite side. Samples, also referred to as lamellae, are typically less than 100 nm thick.

In a scanning transmission electron microscope (STEM), a primary electron beam is focused to a fine spot, and the spot is scanned across the sample surface. Electrons that are transmitted through the work piece are collected by an electron detector on the far side of the sample, and the intensity of each point on the image corresponds to the number of electrons collected as the primary beam impacts a corresponding point on the detector surface.

Because a sample must be very thin for viewing with transmission electron microscopy (whether TEM or STEM), preparation of the sample can be delicate, time-consuming work. The term "TEM" as used herein refers to a TEM or a STEM and references to preparing a sample for a TEM are to be understood to also include preparing a sample for viewing in a STEM. The term "S/TEM" as used herein also refers to both TEM and STEM.

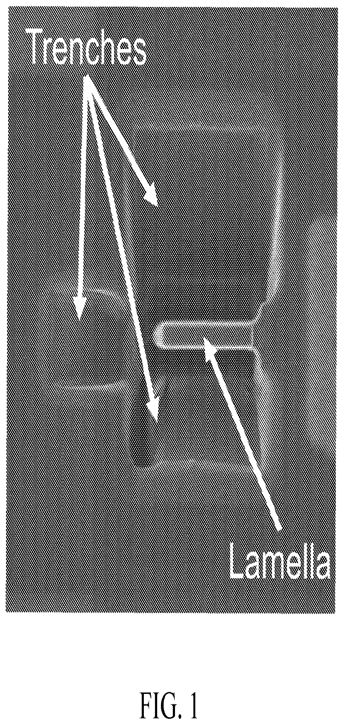

The basic anatomy of a lamella and the surrounding hole (trench) is shown in Figure 1.

The shape and size of the lamella hole is specific to a particular customer process and this invention can account for most variations in lamella hole shape and size.

Fundamental to the lamella preparation process is the formation of a hole (trench) in the sample from which the lamella was cut. In addition, an area surrounding the lamella must be cut away to provide access to the lamella in order to cut it free from the sample. The result is a hole (trench) in the sample which may interfere with lithography steps, pose a risk to post-processing equipment, provide an ingress source into the sample for contamination, or act as a stress raiser, weakening the structural integrity of the sample. For example, the hole (trench) left behind after lamella preparation and liftout from a semiconductor wafer may interfere with subsequent photolithography processes or cause cracking of the wafer during thermal cycling from an annealing or plasma processing step.

To avoid these negative effects, the lamella hole (trench) must be filled so that the wafer can be returned to service.

Ion beam induced deposition (IBID) or electron beam induced deposition (EBID) are typically used to fill these holes, a process which involves the delivery of a gaseous or vapor phase precursor to the sample plane, and utilizing an ion beam or electron beam to decompose the precursor at a specific location to deposit material and fill the hole. These techniques are preferable to global wet chemical filling methods, as they are site specific and do not interfere with the surrounding wafer.

The typical or existing method for creating a lamella from a sample generates a hole geometry with vertical or near-vertical sidewalls as can be seen on the left and right edges of the hole as shown in Figure 1.

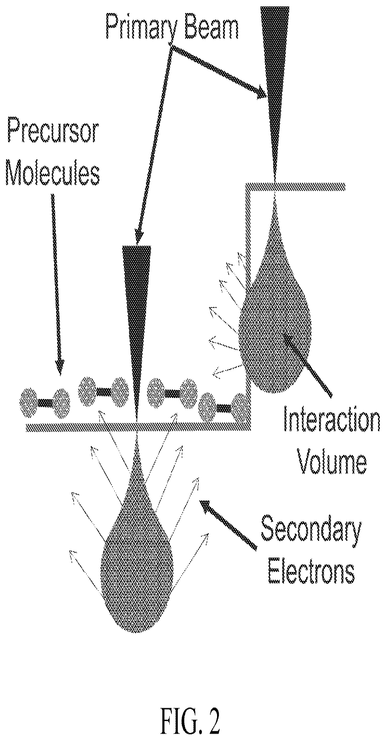

When using EBID and IBID techniques, a fundamental observation is that material will deposit much faster on vertical sidewalls than on a flat horizontal surface. This is caused by the phenomenon known as the "edge effect" and is described as such and shown schematically in Figure 2:
- Secondary electrons (black arrows) are the particles which decompose the precursor molecules (green dumbbells) on the sample surface, creating the deposited material.
- Secondary electrons are generated within the interaction volume (light blue volume) of the primary beam (purple volume) which is generated below the sample surface.
- On a flat surface, the interaction volume is contained entirely within the sample surface and many secondary electrons are absorbed by the sample as they make their way to the surface, effectively reducing the deposition rate.
- On a vertical sidewall, secondary electrons may escape the sample from the top surface as well as through the vertical sidewall as the interaction volume extends outside the surface. This allows many more secondary electrons to escape the material and drastically increases the deposition rate on vertical sidewalls when compared with a flat horizontal surface.

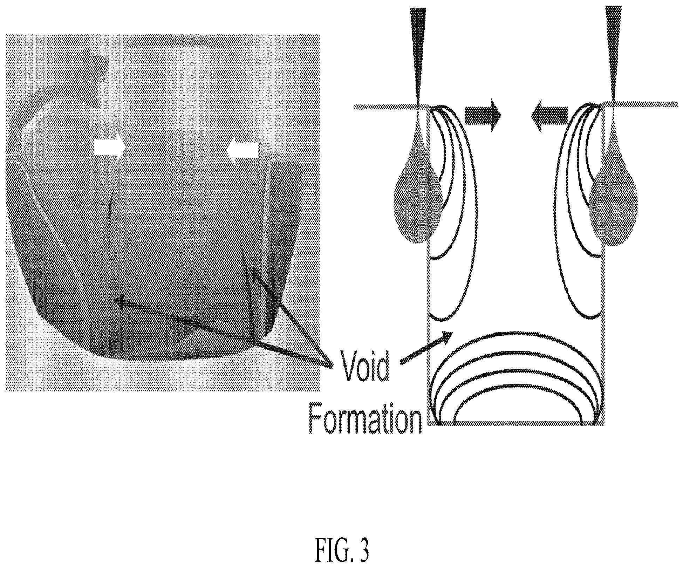

The much faster deposition rate on vertical sidewalls causes asymmetric growth on the vertical walls compared to the flat surface. The growth from the vertical sidewalls will progress towards the centre of the hole as this new growth becomes the new vertical sidewalls, resulting in the sidewall growth hanging over the section of horizontal growth as shown below. This results in void formation in the areas where the sidewall growth and the flat surface growth intersect as shown in Figure 3.

Voids are highly undesirable in the fill process as they can cause the fill material to crack and come loose from the sample during thermal cycling events, which commonly occurs during post-processing following lamella preparation. This can be due to the difference in coefficient of thermal expansion between the sample, the void, and the surrounding fill material which can cause greater expansion in certain directions than others, leading to asymmetric stress and eventual mechanical failure of the fill material.

This mechanical failure can cause extensive damage to equipment, for example if the fill material protrudes from the surface, it may contact the objective lens of an immersion lithography instrument causing extensive damage and costly production delays.

The vertical sidewalls also have the additional disadvantage of causing a phenomenon known as gas shadowing. As the precursor gas is injected onto the sample during the fill process, the molecules can struggle to reach the area at the base of the vertical sidewalls resulting in a lower flux of precursor molecules in this region, leading to slower deposition and the formation of voids.

Conventional approaches for avoiding void formation caused by the enhanced sidewall growth typically utilize a set of alternating and overlapping patterns which reduce the relative beam exposure time to the vertical sidewalls when compared to the flat surface in order to compensate for the asymmetric growth rates. This method however has many disadvantages:
- It significantly increases the complexity of the fill process as multiple filling steps must be carried out.
- It significantly decreases the throughput of this filling process as alternating between pattern types requires additional software and hardware time.
- It increases the complexity of targeting the lamella hole through automated means as now multiple patterns must be placed, increasing the possibility of error.
- The intersection of these multiple patterns can also lead to void formation when the deposition growth on one side of the hole intersects with deposition growth from another side. This can lead to a "zipper-like" void forming at the intersection of two patterns.

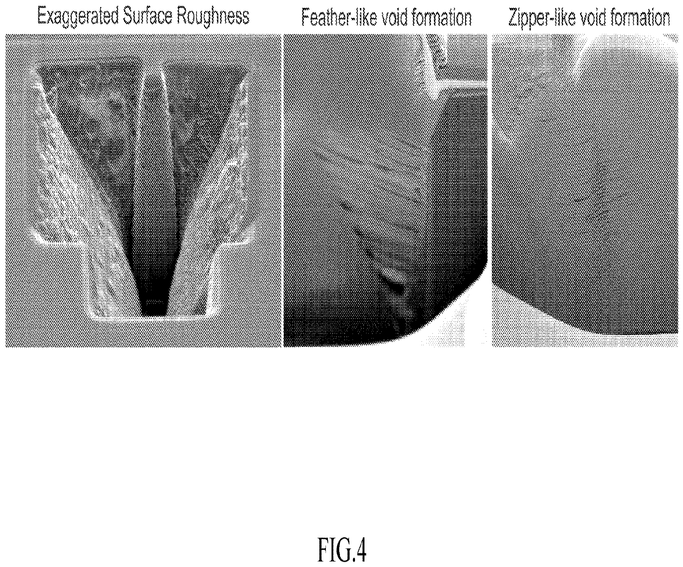

In addition, rough or highly textured surfaces can behave like local regions of alternating vertical and horizontal sidewalls on the scale of the electron or ion beam. This leads to areas of faster over-growth which begin to cascade and form plate- or feather-like growth structures which can propagate into the fill region. This is also undesirable and can lead to the fill material cracking and falling out. Examples of surface problems resulting from void formation, such as exaggerated roughness, are shown in Figure 4.

It is therefore desired to develop a method of filling the trenches or holes formed during lamella preparation that reduces, or preferably eliminates, the formation of voids.

### SUMMARY OF THE INVENTION

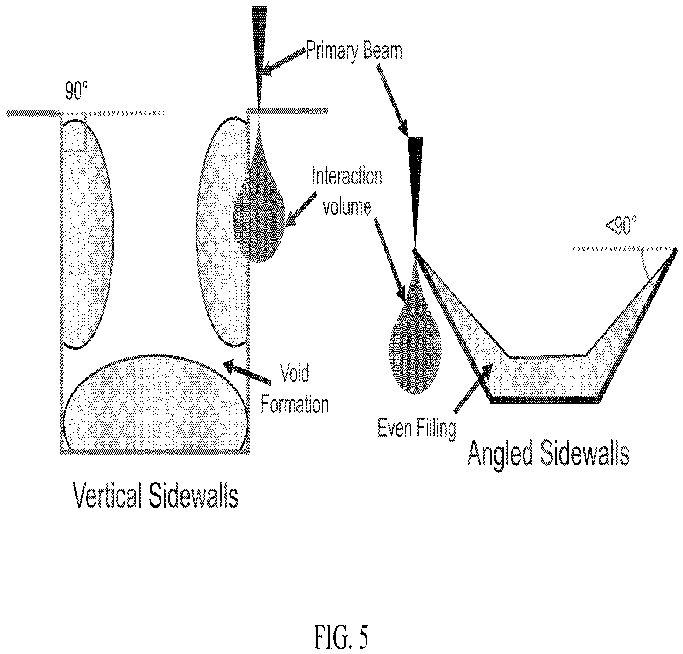

The present inventors have found that if the lamella trenches are milled without vertical sidewalls this ensures even deposition across the entire geometry of the hole, mitigating over-growth type voids, as shown in Figure 5.

Thus, the present invention provides a method of first creating, then filling lamella trenches in a workpiece, wherein the method comprises:
- Directing a focused ion beam or laser to mill trenches on both sides of a region of interest (ROI) to form a lamella (in such a way which is favourable for the mitigation of void formation), the lamella having an observation face for electron microscope observation of the ROI in the observation face;
- Removing the lamella from the workpiece;
- Depositing material into the trenches formed by lamella preparation to fill the trenches (in such a way which is favourable for the mitigation of void formation);
Characterized in that:
During milling the trenches, the focused ion beam or laser is directed to mill progressively closer to the observation face from the trench on each side of the lamella on a Y axis, such that the trench along the Y axis slopes towards the observational face of the lamella and the sidewalls along the X axis slope into the trench, and during the filling of the trenches the fill pattern mimics the shape, size, and geometry of the lamella trenches created.

This is hereinafter referred to as the method of the invention.

The present invention also provides a filled workpiece obtained by the methods defined herein and a filled workpiece, wherein less than 10% of the filled trench is a void.

An apparatus for sample preparation, comprising:
- an ion beam column;
- a stage for supporting a workpiece;
- a controller for controlling the operation of the ion beam column and the stage, the controller including a memory storing computer instructions for carrying out the methods defined herein is also defined herein.

### BRIEF DESCRIPTION OF THE DRAWINGS

For a more complete understanding of the present invention, and the advantages thereof, reference is now made to the following descriptions taken in conjunction with the accompanying drawings, in which:
FIG. 1 - Illustration of a lamella and the surrounding hole (trench).
FIG. 2 - Illustration of how material may deposit much faster on vertical sidewalls than on a flat horizontal surface.
FIG. 3 - Illustration of how faster deposition rate on vertical sidewalls causes asymmetric growth on the vertical walls compared to the flat surface resulting in the sidewall growth hanging over the section of horizontal.
FIG. 4 - Examples of surface problems resulting from void formation, such as exaggerated roughness.
FIG. 5 - Comparision showing how sidewalls formed within the scope of the method of the invention provide even filling compared to vertical sidewalls formed using prior art methods.
FIG. 6 - Dwell and Passes scan pattern within the scope of the method of the invention, wherein the focused ion beam or laser is directed to mill progressively closer to the observation face from the trench on each side of the lamella on a Y axis such that the trench along the Y axis slopes towards the observational face of the lamella and the sidewalls along the X axis slope into the trench.
FIG. 7 - Illustrates an exemplary apparatus for performing the method of the invention.

### DETAILED DESCRIPTION OF THE INVENTION

In this detailed description of the various embodiments, for purposes of explanation, numerous specific details are set forth to provide a thorough understanding of the embodiments disclosed. One skilled in the art will appreciate, however, that these various embodiments may be practiced with or without these specific details. Furthermore, one skilled in the art can readily appreciate that the specific sequences in which methods are presented and performed are illustrative and it is contemplated that the sequences can be varied and still remain within the spirit and scope of the various embodiments disclosed herein.

As noted previously, in the method of the invention defined herein, the method comprises at least the steps of:
- Directing a focused ion beam or laser to mill trenches on both sides of a region of interest (ROI) in a workpiece to form a lamella, the lamella having an observation face for electron microscope observation of the ROI in the observation face;
- Removing the lamella from the workpiece;
- Depositing material into the trenches formed by lamella preparation to fill the trenches;
Characterized in that:
During milling the trenches, the focused ion beam or laser is directed to mill progressively closer to the observation face from the trench on each side of the lamella on a Y axis, such that the trench along the Y axis slopes towards the observational face of the lamella and the sidewalls along the X axis slope into the trench, and during the filling of the trenches the fill pattern mimics the shape, size, and geometry of the lamella trenches created.

The workpiece may be any containing a region of interest (ROI) from which a lamella may be milled. Examples of workpieces include, but are not limited to a silicon wafer for the semiconductor industry, a battery sample, a resin-embedded biological specimen, a frozen biological specimen, or any arbitrary solid sample such as a ceramic or metal workpiece.

The ROI may be predetermined or may be determined during execution of the method of the invention.

The ROI may be determined by any suitable means. In some aspects, the ROI may be determined manually or by using image recognition software. Navigation to the ROI site may be performed manually, through use of a CAD file, or some other file containing information regarding the ROI locations.

Thus, the method of the invention may include the step of identifying one or more regions of interest in the workpiece.

For example, the method of the invention may comprise at least the steps of:
- Identifying a region of interest (ROI) in the workpiece;
- Directing a focused ion beam or laser to mill trenches on both sides of a region of interest (ROI) in the workpiece to form a lamella, the lamella having an observation face for electron microscope observation of the ROI in the observation face;
- Removing the lamella from the workpiece;
- Depositing material into the trenches formed by lamella preparation to fill the trenches ;
Characterized in that:
During milling the trenches, the focused ion beam or laser is directed to mill progressively closer to the observation face from the trench on each side of the lamella on a Y axis, such that the trench along the Y axis slopes towards the observational face of the lamella and the sidewalls along the X axis slope into the trench, and during the filling of the trenches the fill pattern mimics the shape, size, and geometry of the lamella trenches created.

In some aspects, in the method of the invention, more than one lamella may be milled from the workpiece. In this case, the method may be performed using the steps defined which may then be repeated multiple times to capture the additional lamella, or the method may include repeating each step multiple times before moving on to the next step. For example, the method may include milling additional trenches for further regions of interest (ROIs) before removing the lamellae, and filling the trenches. Depending on the workpiece, it may be desired to deposit a protective covering/layer over the lamella site to protect the region of interest (ROI) from damage during the lamella preparation process. Typically, the protective covering/layer may comprise an electrically conductive composite material including metallic crystallites of tungsten or platinum embedded within a carbonaceous matrix.

Thus, the method of the invention may include the step of depositing a protective layer onto the site of the lamella.

For example, the method of the invention may comprise at least the steps of:
- Depositing a protective covering/later over the workpiece in the area of lamella formation;
- Directing a focused ion beam or laser to mill trenches on both sides of a region of interest (ROI) in the workpiece to form a lamella, the lamella having an observation face for electron microscope observation of the ROI in the observation face;
- Removing the lamella from the workpiece;
- Depositing material into the trenches formed by lamella preparation to fill the trenches;
Characterized in that:
During milling the trenches, the focused ion beam or laser is directed to mill progressively closer to the observation face from the trench on each side of the lamella on a Y axis, such that the trench along the Y axis slopes towards the observational face of the lamella and the sidewalls along the X axis slope into the trench, and during the filling of the trenches the fill pattern mimics the shape, size, and geometry of the lamella trenches created.

Alternatively, the method of the invention may comprise at least the steps of:
- Identifying a region of interest (ROI) in the workpiece;
- Depositing a protective covering/later over the workpiece in the area of lamella formation;
- Directing a focused ion beam or laser to mill trenches on both sides of a region of interest (ROI) in the workpiece to form a lamella, the lamella having an observation face for electron microscope observation of the ROI in the observation face;
- Removing the lamella from the workpiece;
- Depositing material into the trenches formed by lamella preparation to fill the trenches;
Characterized in that:
During milling the trenches, the focused ion beam or laser is directed to mill progressively closer to the observation face from the trench on each side of the lamella on a Y axis, such that the trench along the Y axis slopes towards the observational face of the lamella and the sidewalls along the X axis slope into the trench, and during the filling of the trenches the fill pattern mimics the shape, size, and geometry of the lamella trenches created.

In order to form the lamella trenches are milled on either side of the ROI .

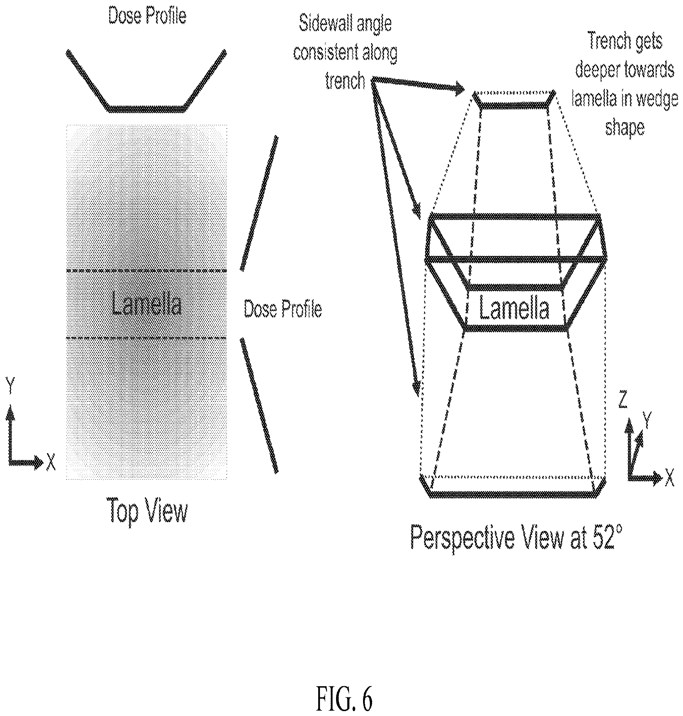

In this step, a scan pattern is used wherein the focused ion beam or laser is directed to mill progressively closer to the observation face from the trench on each side of the lamella on a Y axis as shown in Figure 6, wherein the dose of ions along the Y axis and the dose of ions along the X axis are adjusted through control of the command set sent to the focused ion beam or laser patterning engine, such that the trench along the Y axis slopes towards the observational face of the lamella and the sidewalls along the X axis slope into the trench.

It has been found that when the trench geometry is modified during trench formation such that all sidewall angles are reduced from vertical (i.e. reduced from 90 degrees relative to the workpiece surface as shown in Figure 6), the "edge effect" mechanism responsible for the accelerated sidewall growth no longer poses a risk for void formation. As such, the form of the trenches and how the trenches are formed on either side of the lamella is fundamental to the success of this invention.

Therefore, in a preferred aspect, the scan pattern provides sidewalls along both the X and Y axis with a slope into the trench at an angle of less than 90 degrees with respect to the surface normal of the work piece. Preferably, an angle of from about 80 degrees to about 20 degrees with respect to the surface of the work piece, such as from about 60 to about 40 degrees as shown in Figure 5. For example, the angle may be about 80, 70, 60, 50, 40, 30, or 20 degrees or combinations thereof with respect to the surface normal of the workpiece.

The focused ion beam used for the formation of the trench may have an accelerating voltage from about 16kV to 30kV, a beam current of several nA to several µA, and an ion species of one of Gallium, Xenon, Krypton, Argon, Neon, Oxygen, or Nitrogen, or any mixture of the above species.

The laser may be any laser suitable for milling in an electron microscopy system. In particular, an SEM, TEM, or STEM system. Examples include, but are not limited to, femtosecond lasers.

The scan pattern is chosen such that the surface roughness of the trench following the formation of the trenches is as smooth as possible to avoid the formation of feather-like voids. This can be achieved through alteration of one or more of the following patterning parameters: dwell time, overlap of the beam from one point to the next, intentional defocus of the beam spot, number of patterning passes, or the addition of one or more enhancing gas species. The optimal parameter space could be determined by a Design of Experiment (DOE) whereby the combination of parameters are altered in a unified manner and a trench milling procedure is run. The resultant surface roughness is measured using an SEM, Atomic Force Microscope (AFM), or some other form of surface roughness analysis and the results are used to converge on the optimal set of parameters.

The scan pattern may be defined by generating a point-by-point instruction set which is sent to the patterning controller. This instruction set may comprise a set of beam coordinates, dwell times or any other instructions relevant to fine control of the patterning beam. The instruction set defines the structure of the lamella trenches described above and allows the flexibility to alter the ion dose in multiple dimensions without limitations of utilizing conventional patterns.

The scan pattern may be generated programmatically, or manually by a user. The scan pattern may be generated in advance of the lamella preparation and stored in the patterning controller, control software, or local computer, or the scan pattern may be generated immediately prior to the formation of the lamella trenches.In the method of the invention, the scan pattern milling may be performed in two sections as two individual patterns, one for the upper trench and one for the lower trench, or the scan pattern milling may be performed as a continuous pattern with a gap in the middle to produce the lamella shape.

In some variants of this invention, an additional trench may be prepared on the side of the lamella cavity to provide access for the manipulator used for lamella removal. The formation of this additional trench is performed in a method similar to the lamella trenches, wherein the dose of ions along the Y axis and the dose of ions along the X axis are adjusted through control of the command set sent to the focused ion beam or laser patterning engine, such that the trench along the X axis slopes towards the longitudinal edge of the lamella and the sidewalls along the Y axis slope into the trench.

It should be noted that the lamella formed after this step may need further thinning prior to imaging in a S/TEM instrument. In this case, the further milling patterns may be used in order to thin the lamella to its final dimensions. These thinning steps may be performed before or after removal of the lamella from the sample.

In order to remove the lamella, it may be necessary to undercut the lamella, i.e. to remove material at the base of the lamella to separate it from the sample. Thus, the method of the invention may include the step of undercutting the lamella.

In order to undercut the lamella, the sample is typically tilted relative to the FIB in order to mill under the lamella. Typically, the sample is tilted from about 52 degrees to about 45 degrees normal to the sample surface. Alternatively, or additionally, the FIB position may be tilted.

After the formation of the trenches and any optional thinning steps, the lamella is removed from the workpiece. Any method may be used to remove the lamella. For example, the lamella may be removed by a micromanipulator, nanomanipulator, or nanotweezers.

Finally, the trenches are filled by depositing a desired fill material into the trenches generated by the lamella preparation process, in such a manner which mitigates the formation of voids.

This is performed positioning a precursor delivery system near the ROI that injects vapors from a precursor gas or combination of precursor gases and directing a scanning a charged particle beam (either ions or electrons) over the ROI.

The charged particle beam creates secondary electrons and/or excited surface atoms which locally decompose adsorbed precursor gas molecules into volatile and non-volatile fragments. The non-volatile fragments remain as deposited material.

The non-volatile fragments may be electrically insulating, electrically conductive, or moderately conductive depending on the sample requirements. For example, injecting vapors of tetra ethyl orthosilicate with or without simultaneous injection of water vapor will produce a deposit of silicate-based insulating material in the beam scan region. Similarly, the injection of tungsten hexacarbonyl will produce a deposit of tungsten-based conductive material in the beam scan region.

The speed, quality, purity, porosity, and texture of the fill can be altered by the manipulation of one or more of the following patterning parameters: accelerating voltage, beam current, dwell time, overlap of the beam from one point to the next, intentional defocus of the beam spot, number of patterning passes, delay time between passes to allow for the replenishment of precursor molecules, or the addition of one or more enhancing gas species.

The charged particle beam used for the filling of the lamella trenches may have an accelerating voltage from about 30kV to less than 100V, a beam current of several nA to several µA, and may be comprised of electrons, or any of the ion species: Gallium, Xenon, Krypton, Argon, Neon, Oxygen, or Nitrogen, or any mixture of the above species.

The scan pattern used to fill the lamella trenches may be defined by generating a point-by-point instruction set which is sent to the patterning controller. This instruction set may comprise a set of beam coordinates, dwell times or any other instructions relevant to fine control of the patterning beam. The instruction set defines the structure of the fill material and is created such that it mimics the shape, size, and geometry of the lamella trenches created in the previous activities. Defining the scan pattern in a point-by-point fashion allows the flexibility to alter the charged particle dose in multiple dimensions without limitations of utilizing conventional patterns.

The scan pattern may be generated programmatically, or manually by a user. The scan pattern may be generated in advance of the lamella preparation and stored in the patterning controller, control software, or local computer, or the scan pattern may be generated immediately prior to the filling of the lamella trenches.

The filling of the lamella trenches using the described invention will result in a material fill comprising of less than 10% voids, less than 5% voids, or less than 1% voids, with a void being defined as a hole greater than 10nm, greater than 50nm, or greater than 100nm.

An example method within the scope of the present invention is described below.

A lamella preparation method within the scope of the method defined herein may be carried out in the following non-limiting manner:
- A region of interest (ROI) is identified and located using a SEM, FIB, optical microscope, or some other means of navigation.
- A protective layer may or may not be deposited on the sample surface to protect the ROI from damage during the lamella preparation process.
- A fiducial or fiducials may be placed in proximity to the ROI for registration and targeting by a computer vision system.
- Trenches are milled using the FIB or laser at the front and rear of the ROI to form a thin slice of material, known as the lamella.
- The lamella is attached to a manipulator and then cut free from the bulk workpiece.
- The lamella is transferred to a lamella carrier suitable for imaging in a TEM instrument. The lamella is attached to the lamella carrier and cut free from the manipulator.
- The lamella may be thinned using the FIB to an appropriate thickness for imaging in the TEM, or the thinning may be performed in an external instrument.

The trench created in the workpiece and any fiducials created on the surface of the workpiece may then be filled using some form of material deposition such as Electron or Ion Beam Induced Deposition.The present invention also provides a filled workpiece obtained by the method defined in claim 1.

In the filled workpiece, due to the use of the method of the invention, typically less than 10% of the filled trench comprises a void (i.e. an unfilled space). Preferably, less than 5% or less than 2% of filled trench comprises a void.

The present invention also provides an apparatus for sample preparation, comprising:
- an ion beam column;
- a stage for supporting a work piece;
- a controller for controlling the operation of the ion beam column and the stage, the controller including a memory storing computer instructions for carrying out the method of the invention as defined herein.

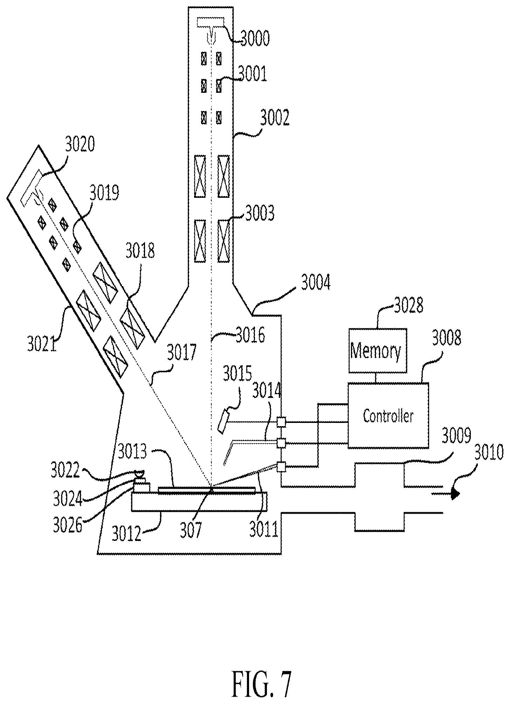

FIG. 7 shows a typical dual charged particle beam system that can be used to perform the steps of different embodiments of the invention. The system has an electron beam column 3002, with electron source 3000 and beam shaping lenses 3001 and 3003, and directs electron beam 3016. The system also has an ion beam column 3021, with an ion source 3020, and ion focusing lenses 3019 and 3018, and directs ion beam 3017. The beams are directed towards a sample 3013 containing region of interest 307, the sample 3013 positioned on a 5 -axis primary stage 3012 that can moved in the x-y-z directions, rotate, and tilt.

A TEM grid holder 3024 for holding TEM grids 3022 is mounted on the primary stage. Optionally, the TEM grid holder 3024 can be mounted on a secondary stage 3026 to prove additional degrees of freedom for manipulating the TEM grid for lamella attachment and for processing the lamella. The system also includes a particle detector 3015, a gas introduction system 3014, and a sample manipulation probe 3011, which can move the probe tip in the x-y-z direction as well as rotate about the probe axis. The charged particle beam columns, detector, gas introduction system, and sample manipulation probe are contained in a vacuum chamber 3004, which is pumped by vacuum pump 300. The charged particle columns, detector, gas introduction system, and sample probe are controlled by a controller 3008, which can retrieve computer instructions stored on memory 3028.In view of the many possible embodiments to which the principles of the disclosed invention may be applied, it should be recognized that the illustrated embodiments are only preferred examples of the invention and should not be taken as limiting the scope of the invention. Rather, the scope of the invention is defined by the following claims. We therefore claim as our invention all that comes within the scope and spirit of these claims.

## Claims

1. A method of creating and filling lamella trenches in a workpiece, wherein the method comprises:
• Directing a focused ion beam or laser to mill trenches on both sides of a region of interest (ROI) to form a lamella, the lamella having an observation face for electron microscope observation of the ROI in the observation face;
• Removing the lamella from the work piece;
• Depositing material into the trenches formed by lamella preparation to fill the trenches;
**Characterized in that**:
During milling the trenches, the focused ion beam or laser is directed to mill progressively closer to the observation face from the trench on each side of the lamella on a Y axis, such that the trench along the Y axis slopes towards the observational face of the lamella and the sidewalls along the X axis slope into the trench, and during the filling of the trenches the fill pattern mimics the shape, size, and geometry of the lamella trenches created.

2. The method according to claim 1, wherein the sidewalls along the X axis slope into the trench with an angle of less than 90 degree with respect to the surface of the work piece.

3. The method according to claim 1, wherein the sidewalls along the X axis slope into the trench with an angle of from about 80 degrees to about 40 degrees with respect to the surface of the work piece.

4. The method according to claim 1, wherein the trenches are milled using a scan pattern specific to the dimensions, orientation, and nature of the trench being filled.

5. The method according to claim 4, wherein the scan pattern is defined in a point-by-point fashion.

6. The method of claim 1, wherein the filled material is deposited using a scan pattern specific to the dimensions, orientation, and nature of the trench being filled.

7. The method according to claim 6, wherein the scan pattern is defined in a point-by-point fashion.

8. The method of claim 1, wherein the workpiece may be a semi-conductor, a battery sample, a resin-embedded biological specimen, a frozen biological specimen, or any arbitrary solid sample such as a ceramic or metal workpiece.

9. A filled workpiece obtained by the method of claim 1.

10. A filled workpiece, wherein less than 10% of the filled trench is a void.

11. An apparatus for sample preparation, comprising:
an ion beam column;
a stage for supporting a work piece;
a controller for controlling the operation of the ion beam column and the stage, the controller including a memory storing computer instructions for carrying out the steps of claim 1.
